# EUROPEAN PATENT APPLICATION

(11) **EP 0 538 054 A1**
(43) Date of publication of application: **21.04.1993**
(21) Application number: 92309469.2
(22) Date of filing: 16.10.1992
(51) Int. Cl.: H01L 27/092, H01L 21/82

(54) **Semiconductor integrate circuit device having N- and P- type insulated-gate field effect transistors and its production method**

(30) Priority: 16.10.1991 JP 267414/91
(71) Applicant: NEC CORPORATION, Tokyo (JP)
(72) Inventor: Wakabayashi, Masaru, Minato-ku, Tokyo (JP)
(74) Representative: Moir, Michael Christopher

(57) **Abstract**

A semiconductor integrated circuit device having n- and p-type insulated-gate FETs is provided. First and second side wall spacers (29a, 29b) each made of an insulating film are provided respectively around the gate electrode (25a) of the p-type FET and the gate electrode (25b) of the n-type FET and, a third side wall spacer (29c) made of an insulating film is additionally provided only on the side surface of the second side wall spacer. The first and second side wall spacers are substantially equal in thickness to each other. As a result, the thickness of the spacer of the p-type FET becomes larger than that of the n-type FET, thus being capable of forming the spacers with the optimum thickness respectively for the nand p-type FETs. Consequently, satisfactory performance and reliability can be provided on both types of the FETs.

## Description

### BACKGROUND OF THE INVENTION

### 1. Field of the Invention

This invention relates to a semiconductor integrated circuit device and its production method and more particularly, to a semiconductor integrated circuit device having n-type and p-type insulated-gate field effect transistors and having side wall spacers formed on the side surfaces of the gate electrodes of these transistors for providing a lightly doped drain (LDD) structure to both transistors and its production method.

### 2. Description of the Related Art

Recently, there is an increasing trend to make semiconductor integrated circuit devices smaller in size accompanied with the growing tendency toward high integration and high speed performance. Under such a circumstance, in the case of being a semiconductor integrated circuit device having n- and p-channel MOS field effect transistors (MOS transistors) formed on a semiconductor substrate, the characteristic degradation of the MOS transistors themselves due to hot-electron injection has been arisen as a problem to be overcome. In order to cope with such problem, lightly doped drain (LDD) structured ones having an electric field relaxed in the vicinity of the drain region have been frequently used. The LDD structure is that side wall spacers made of insulating films are provided on the side surfaces of the gate electrodes of the MOS transistor and such regions that are lower in impurity concentration than the source region and drain regions are formed in self-alignment in the semiconductor substrate, thus the effective channel length being increased by these regions having lower impurity concentrations.

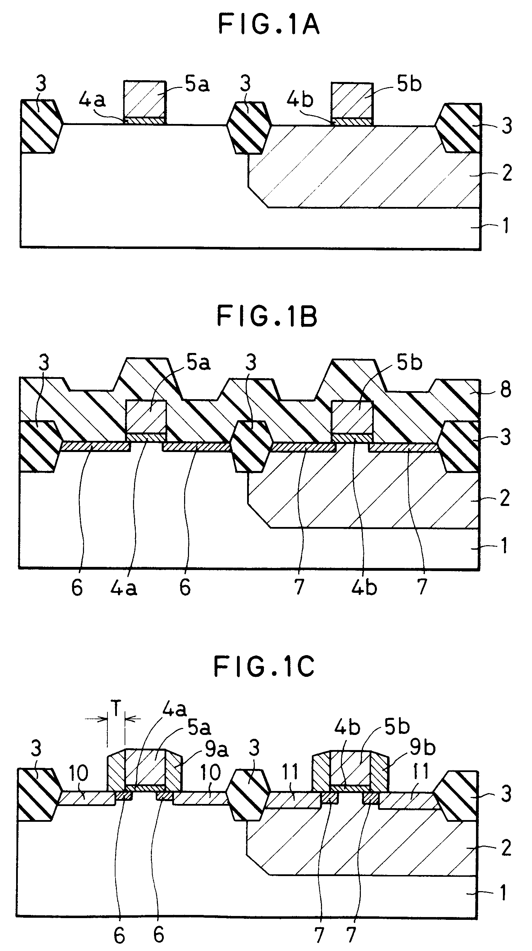

A conventional semiconductor integrated circuit device having n and p MOS transistors and having the LDD structure is shown in Fig. 1C, which has an n MOS transistor and a p MOS transistor adjacently formed respectively in the left and right side of the figure.

In Fig. 1C, on the surface of a p-type silicon substrate 1, an n well 2 and a field oxide film 3 (600 nm thick) for device isolation are formed. On the surface of each active region formed by the field oxide film 3, in an n-channel region, that is, an area other than the n well 2, a gate oxide film 4a (15 nm thick) and a gate electrode 5a (400 nm thick) made of a polysilicon film are laminated in this order, and in the n well 2, or in a p-channel region, a gate oxide film 4b (15 nm thick) and a gate electrode 5b (400 nm thick) made of a polysilicon film are laminated in this order. On the side surfaces of the gate electrodes 5a and 5b, side wall spacers 9a and 9b each made of a silicon oxide (SiO₂) film are respectively forced so as to surround them.

In the n-channel region, a pair of n⁻ diffusion regions 6 having low impurity concentration and a pair of n⁺ diffusion regions 10 having high impurity concentration are respectively formed symmetrically with respect to the gate electrode 5a. One of the n⁺ diffusion regions 10 becomes the source region and the other becomes the drain region. Similarly, in the p-channel region, a pair of p⁻ diffusion regions 7 having low impurity concentration and a pair of p⁺ diffusion regions 11 having high impurity concentration are respectively formed symmetrically with respect to the gate electrode 5b, one of the regions 11 becoming the source region and the other thereof becoming the drain region.

On the surface of the device of Fig. 1C, an inter-layer insulating film made of silicon dioxide and a wiring layer made of an aluminum alloy are formed in this order (which are not shown here). The wiring layer is contacted through contact holes respectively to the gate electrodes 5a and 5b and a pair of diffusion regions 10 and a pair of diffusion regions 11.

With the conventional device structured as above, the n⁻ diffusion regions 6 and p⁻ diffusion regions 7 are formed respectively beneath the side wall spacers 9a and 9b and as a result, the effective channel length of each of the n⁻ and p-type MOS transistors can be increased.

The conventional device as shown above is generally produced as follows;
First, on the surface of the p silicon substrate 1, the n well 2 and the field oxide film 3 are selectively formed and then, on the active regions formed by the field oxide films 3, the gate oxide film 4a and the gate electrode 5a of a polysilicon film are laminated in the n-channel region in this order and the gate oxide film 4b and the gate electrode 5b of a polysilicon film are laminated in the p-channel region in this order, the state of which is shown in Fig. 1A.

Subsequently, phosphorus (P) ion is implanted selectively into the n-channel region at a dose of 5x10¹³ cm⁻² with the gate electrode 5a as a mask thereby forming the pair of the n⁻ diffusion regions 6 low in impurity concentration. In addition, boron (B) ion is implanted selectively into the p-channel region at a dose of 3x10¹³ cm⁻² with the gate electrode 5b as a mask thereby forming the pair of the p⁻ diffusion regions 7 low in impurity concentration.

Next, on the substrate 11 thus ion-implanted, a silicon dioxide film 8 (200 nm thick) is formed by a chemical vapor deposition (CVD) method, the state of which is shown in Fig. 1B. Subsequently, a mask having a predetermined pattern is disposed on the oxide film 8 and then, the anisotropic, reactive ion etching (RIE) technique using CHF₃ gas is applied to the oxide film 8, remaining the film 8 only on the side surfaces of the gate electrodes 5a and 5b. Thus, as shown in fig. 1C, the side wall spacers 9a and 9b of a silicon oxide film are respectively formed so as to surround the gate electrodes 5a and 5b.

Next, arsenic (As) ion is implanted selectively into the n-channel region at a dose of 5x10¹⁵ cm⁻² with the gate electrode 5a and the side wall spacer 9a as a mask thereby forming the pair of the n⁺ diffusion regions 10. Similarly, boron fluoride (BF₂) ion is implanted into the p-channel region at a dose of 5x10¹⁵ cm⁻² with the gate electrode 5b and the side wall spacer 9b as a mask thereby forming the pair of the p⁺ diffusion regions 11. Thereafter, the heat treatment is carried out at 900 °C for ten minutes under the nitrogen atmosphere thereby annealing the regions 10 and 11. Thus, the n⁺ diffusion regions 10 and p⁺ diffusion regions 11 respectively becoming the source region and the drain region of each transistor are formed in self-alignment, the state of which is shown in Fig. 1C.

Then, the inter-layer insulating film of silicon oxide is deposited on the entire surface of the substrate 1, then, contact holes are formed in the inter-layer insulating film and thereafter, the wiring layer of an aluminum alloy is formed thereon and patterned. Consequently, the conventional semiconductor integrated circuit device having n and p MOS transistors is produced.

With the conventional device described as above, some disadvantageous points are frequently generated on performance and reliability in one or both of the n and p MOS transistors.

Thus, an object of this invention is to provide a semiconductor integrated circuit device having n-type and p-type insulated gate field effect transistors capable of obtaining satisfactory performance and reliability on both types of the insulated gate field effect transistors and ap roduction method of the same.

Another object of this invention is to provide a semiconductor integrated circuit device having n- and p-type insulated gate field effect transistors and a bipolar transistor whose emitter and base can be formed in self-alignment without increasing the number of production steps and the performance and reliability of the both types of the field effect transistors and the bipolar transistor can be satisfactorily obtained.

### SUMMARY OF THE INVENTION

In a first aspect of this invention, a semiconductor integrated circuit device having n- and p-type insulated-gate field effect transistors (FET), each having a lightly doped drain (LDD) structure, is provided.

This device has a first side wall spacer and a second side wall spacer, each made of an insulating film, respectively formed around the gate electrode of the p-type insulated-gate FET and the gate electrode of the n-type insulated-gate FET, and a third side wall spacer mede of an insulating film formed only on the outside surface of the second side wall spacer.

Generally, the diffusion constant of an ion (for example, boron) injected into the substrate of the p-type insulated-gate FET is larger than that of an ion (for example, phosphorus or arsenic) injected into the substrate of the n-type insulated-gate FET, which means that the p⁺ diffusion region is easy to be expanded to the channel side by the heat treatment after ion-implantation. As a result, the p-type insulated-gate FET having the LDD structure has the short channel effect remarkably appeared, resulting in easy reduction of the effective channel length. Accordingly, the p-type insulated-gate FET is required to set the thickness of the side wall spacer so as to be rather large.

On the other hand, in the n-type insulated-gate FET having the LDD structure, if the thickness of the side wall spacer is large, the n⁻ diffusion region to be formed becomes long, so that the series resistance to the pair of the n⁺ diffusion regions, that is , to the source and drain regions is increased. As a result, it is impossible to make the thickness of the side wall spacer so large.

Accordingly, the semiconductor integrated circuit device of the first aspect features that around the grate electrode of the n-type insulated-gate FET, only a first side wall spacer is provided and around the gate electrode of the p-type insulated-gate FET, a second side wall spacer substantially equal in thickness to the first side wall spacer is provided and a third side wall spacer is provided on the outside surface of the second side wall spacer thereby making the total thickness of the side wall spacers of the p-type insulated-gate FET larger than that of the n-type insulated-gate FET, so that the side wall spacers each having the optimum thickness can be formed on both types of the transistors, thus providing satisfactory performance and reliability to both transistors.

In a preferred embodiment, the second side wall spacer of the p-type FET has the thickness substantially equal to that of the first side wall spacer of the n-type FET. This is advantageous in that there is no need to take account of the types of the FET, n and p, when the first abd second side wall spacers are formed.

The first, second and third side wall spacers may be made of an insulating film of the same material or made of insulating films of different materials from each other.

The thickness of the first and second side wall spacers are preferable to be set at the optimum value in accordance with the size of the gate electrode taking account of the performance and reliability of the n-type FET. The thickness of the third side wall spacer is preferable to be set the sum of the thicknesses of the second and third side wall spacers at the optimum value in accordance with the size of the gate electrode taking account of the performance and reliability of the p-type FET.

A bipolar transistor can be provided on the semiconductor substrate, In this case, it is preferable that an insulating film of the same material as that of the third side wall spacer is provided on the emitter region and base region of the bipolar transistor and that the emitter and base regions are formed in self-alignment.

In a second aspect of this invention, a production method of the semiconductor integrated circuit device of the first aspect is provided.

This production method comprises a steps of forming a first side wall spacer and second side wall spacer, each made of a first insulating film, respectively around the gate electrode of the n-type insulated-gate FET and the gate electrode of the p-type insulated-gate FET, and a step of forming a third side wall spacer made of a second insulating film only on the outside surface of the second side wall spacer of the p-type FET.

In a preferred embodiment, the step of forming the third side wall spacer comprises a step of forming a second insulating film so as to cover the surfaces of the both type FETs having the first and second side wall spacers formed and a step of an isotropically etching the second insulating film so that the second insulating film is remained in the predetermined area around the gate electrode of the p-type FET and in the area whidh covers the surface of the n-type FET therewith.

The first and second insulating films may be made of the same material or made of different materials from each other.

In a third aspect of this invention, a semiconductor integrated circuit device having n- and p-type insulated-gate FETs, each having the LDD structure, is provided.

This device is that a side wall spacer, made of an insulating film, formed on the side surface of the gate electrode of the p-type insulated-gate FET is made larger in thickness than the side wall spacer, made of an insulating film, formed on the side surface of the n-type insulated-gate FET.

The side wall spacer of the p-type FET is preferable to be made of a single insulating film.

The device in the third aspect makes it possible to provide satisfactory performance and reliability to both types of the transistors for the same reasons as in the first aspect.

In the device of this aspect, with a mask disposed on the insulating film for forming the side wall spacers, a through-hole formed at the position corresponding to the gate electrode of the p-type FET is made larger in size than a through-hole formed at the position corresponding to the gate electrode of the n-type FET and, and the anisotropic reactive ion etching (RIE) using the mask is carried out, thus being capable of easily producing the device of this aspect.

In a fourth aspect of this invention, a production method of a semiconductor integrated circuit device having n- and p-type insulated-gate FETs, each having the LDD structure, and a bipolar transistor formed on a semiconductor substrate is provided.

This production method comprises a step of forming a first side wall and a second side wall, each made of a first insulating film, respectively on the side surface of the gate electrode of the n-type FET and the side surface of the gate electrode of the pptype FET, a step of forming a second insulating film on the surface of the n- and p-type FETs respectively having the first and second side walls formed thereon and on the surface of the bipolar transistor, and a step of etching the second insulating film with a mast disposed of the second insulating film so that the second insulating film around the second wall of the p-type FET and in the other area than the emitter and base regions of the bipolar transistor may be removed and thereby a third side wall spacer is formed of the insulating film remained around the second side wall spacer and at the same time, a masking insulating film having through-holes respectively extended to the surfaces of the emitter and base regions is formed on the emitter and base regions.

In a preferred embodiment, this production method further comprises a step of forming an emitter electrode on the masking insulating film on the emitter and base regions by a lithography technology, and a step of performing ion-implantation into the emitter and base regions with a resist and the masking insulating film as a mask, while a resist film used for forming the emitter electrode is being remained thereon, with the remained resist film and the mask ing insulating film as a mask.

According to the production method of this aspect, without adding any step newly to the production method of the second aspect, the emitter and base regions of the bipolar transistor can be formed in self-alignment. As a result, the performance and reliability of the bipolar transistor also can be improved additionally to the improvement of those of the n- and p-type insulated-gate FETs.

In the first, second, third and fourth aspects, the insulated-gate FET is not limited to an MOS transistor, and as a result, any other transistor man be applied for this purpose, if it is a field effect transistor having an insulated-gate.

### BRIEF DESCRIPTION OF THE DRAWINGS

Figs. 1A to 1C cross-sectionally show a conventional semiconductor integrated circuit device.

Figs. 2A to 2C cross-sectionally show a semiconductor integrated circuit device of a first embodiment of this invention in the order of processing procedures in its production method.

Figs. 3A to 3D cross-sectionally show a semiconductor integrated circuit device of a second embodiment of this invention in the order of the processing procedures in its production method.

Fig. 4 is a cross-sectional view of a semiconductor integrated circuit device of a third embodiment of this invention.

### DESCRIPTION OF THE PREFERRED EMBODIMENTS

Preferred embodiments of this invention will be described below while referring to the drawings.

### [First Embodiment]

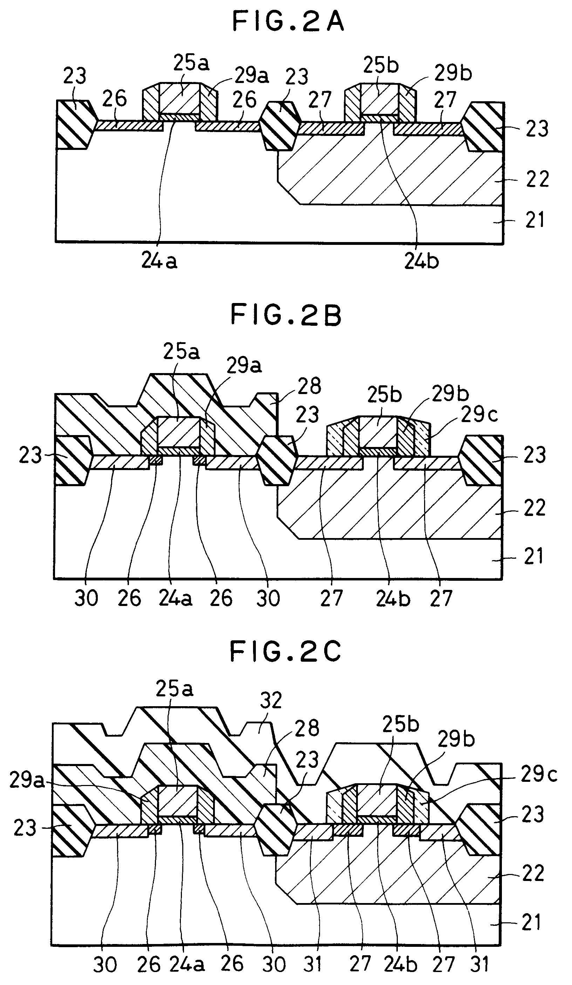

A semiconductor integrated circuit device according to a first embodiment of this invention is shown in Fig 2C, which has n-channel MOS transistor (n MOS transistor) and a p-channel MOS transistor (p MOS transistor) each having the LDD structure. In this device, an n MOS transistor and a p MOS transistor respectively formed adjacently on the left and right sides of the figure.

In fig. 2C, an n well 22 and a field oxide film 23 (600 nm thick) for device isolation are formed on the surface of a p-type silicon substrate 21. On the surface of each active region formed by the field oxide film 23, in the n-channel region, that is, the area other than the n well 22, a gate oxide film 24a (400 nm thick) and a gate electrode (400 nm thick) of a polysilicon film are laminated in this order, and in the p-channel region, that is, in the n well 22, a gate electrode 24b (15 nm thick) and a gate electrode 25b (400 nm thick) of a polysilicon film are laminated in this order. On the side surfaces of the gate electrodes 25a and 25b, a first side wall spacer 29a and a second side wall spacer 29b (each about 200 nm thick) of silicon dioxide (SiO₂) films are respectively formed so as to surround them.

A third side wall spacer 29c (about 200 nm thick) of a silicon dioxide (SiO₂) film is formed on the side surface of the second side wall spacer 29b of the gate electrode 25b of the p MOS transistor so as to surround the periphery thereof.

As shown above, this device is that the gate electrode 25a of the n MOS transistor is surrounded by the first side wall spacer 29a only and on the other hand, the gate electrode 25b of the p MOS transistor is doubly surrounded by the second and third side wall spacers 29a and 29c. As a result, the thickness of the spacer insulating film provided around the gate electrode 25a is about 200 nm and on the other hand, the total thickness of the spacer insulating films provided around the gate electrode 25b is about 400 nm, thus the latter becoming substantially twice the former.

In the n-channel region, a pair of n⁻ diffusion regions 26 having low impurity concentration and a pair of n⁺ diffusion regions 30 having high impurity concentration are respectively formed symmetrically with respect to the gate electrode 25a, one of the regions 30 becoming the source region and the other thereof becoming the drain region. In the p-channel region, similarly, a pair of p⁻ diffusion regions 27 having low impurity concentration and a pair of p⁺ diffusion regions 31 having high impurity concentration are respectively formed symmetrically with respect to the gate electrode 25b, one of the region 31 becoming the source region and the other thereof becoming the drain region.

The surface of the device shown in Fig. 2C is covered with an inter-layer insulating film 32 of silicon dioxide and a wiring layer (not shown) of an aluminum alloy is formed thereon. The wiring layer is connected through contact holes formed in the inter-layer insulating film 32 respectively to the gate electrodes 25a and 25b and n⁺ diffusion regions 30 and 31.

In the above-mentioned device, the n MOS transistor has the n⁻ diffusion regions 26 having low impurity concentration formed beneath the first side wall spacer 29a of the gate electrode 25a and the p MOS transistor has the p⁻ diffusion regions 27 having low impurity concentration formed beneath the second and third side wall spacer 29b and 29c of the gate electrode 25b, thus becoming the LDD structure. As a result, the effective channel length of each of the n and p MOS transistors can be improved.

In addition, the length of the p⁻ diffusion regions 27 becomes about two times the length of the n⁻ diffusion regions 26 corresponding to the relation between the thickness of the first side wall spacer 29a and those of the second and third side wall spacers 29b and 29c, which means that the effective channel lengths of both n and p MOS transistors can be set respectively to the optimum values. Accordingly, satisfactory performance and reliability can be obtained on both n and p MOS transistors.

A production method of the semiconductor integrated circuit device will be explained below by referring to Figs. 2A to 2C.

On the surface of the p-type silicon substrate 21, the n well 22 and the field oxide film 23 (600 nm thick) are selectively formed, and on the surfaces of active regions formed by the field oxide film 23, the gate oxide films 24a and 24b (each 15 nm thick) and the gate electrodes 25a and 25b (each 400 nm thick) of a polysilicon film are laminated in this order.

Subsequently, phosphorus (P) ion is implanted selectively into the n-channel region at a dose of 5 x 10¹³ cm⁻² with the gate electrode 25a as a mask thereby forming the pair of the n⁻ diffusion layers 26 having low impurity concentration in self-alignment. In addition, boron (B) ion is implanted selectively into the p-channel region at a dose of 3 x 10¹³ cm⁻² with the gate electrode 25b as a mask thereby forming the pair of the p⁻ diffusion layers 27 having low impurity concentration in self-alignment, the state of which is shown in Fig. 2B. The above-mentioned procedures are the same as those of the conventional one already explained above.

Next, on the substrate 21 thus ion-implanted, a first oxide film (200 nm thick, not shown) of silicon dioxide is formed by the CVD method. Then, a mask having a predetermined pattern is disposed on the first oxide film and the anisotropic reactive ion etching (RIE) technique using CHF₃ gas is applied to the first oxide film thereby remaining the first oxide film only on the side surfaces of the gate electrodes 25a and 25b. As a result, as shown in Fig. 2C, the first and second side wall spacers 29a and 29b (each about 200 nm thick) are respectively formed on the side surfaces of the gate electrodes 25a and 25b so as to surround them.

Then, arsenic (As) ion is implanted selectively into the n-channel region at a dose of 5x10¹⁵ cm⁻² with the gate electrode 25 and first side wall spacer 29a as a mask. As a result, the pair of the n⁺ diffusion regions 30, that is, the source and drain regions of the n MOS transistor are formed in self-alignment.

Next, on the surface of the device thus ion-implanted, a second oxide film 28 (200 nm thick) of silicon dioxide is formed by the CVD method, then, a mask having a predetermined pattern having an opening at the position corresponding to the p-channel region is disposed thereon and the anisotropic reactive ion etching technique using CHF₃ gas is applied selectively to the oxide film 28 only on the p-channel region, thus remaining the second oxide film 28 only on the side surfaces of the second side wall spacer 29b and the gate electrode 25b. Thus, the third side wall spacer 29c (about 200 nm thick) is formed on the side surface of the second side wall spacer 29a, the state of which is shown in Fig. 2B. As seen from Fig. 2B, the second bride film 28 is remained on the n-channel region at that time.

Next, boron fluoride (BF₂) ion is implanted selectively into the p-channel region at a dose of 5x10¹⁵ cm⁻² with the gate electrode 25b and the second and third side wall spacers 29b and 29c as a mask, thus the source region and drain region, namely, the pair of the p⁺ diffusion layers 31 of the p MOS transistor is formed in self-alignment. Thereafter, heat treatment is carried out at 900 °C for ten minutes under the nitrogen atmosphere for annealing.

Subsequently, as in the prior art, the inter-layer insulating film 32 of silicon dioxide is formed on the entire surface thereof, the state of which is shown in Fig. 2C. Then, contact holes are formed in the inter-layer insulating film 32 and a wiring layer of an aluminum alloy is formed thereon. Thus, the semiconductor integrated circuit device of this embodiment is finished.

### [Second Embodiment]

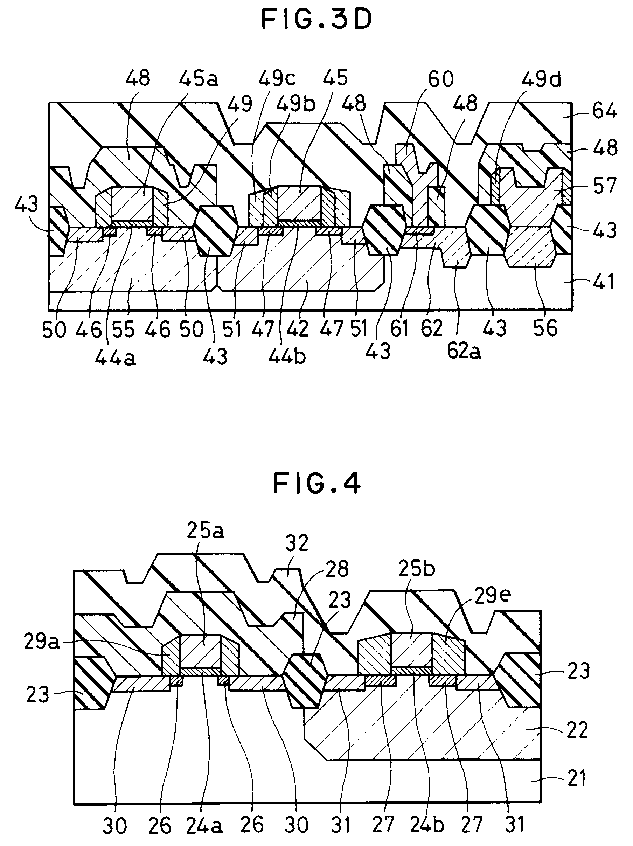

A semiconductor integrated circuit device of a second embodiment of this invention is shown in Fig. 3D, which has n and p MOS transistors each having the LDD structure and a bipolar transistor. The n MOS transistor, the p MOS transistor and the bipolar transistor are adjacently disposed at the left side, the center and the right side of the figure, respectively.

In Fig. 3D, on the surface of a silicon substrate 41 having an n-type epitaxial layer are selectively formed an n well 42, a p well 55 and a field oxide film 43 (600 nm thick) for the device insulating isolation. Referring to the active regions formed by the field oxide film 43, in the p well 55, that is, in the n-channel region, a gate oxide film 44a and a gate electrode 45a of an n⁺ polysilicon film are laminated in this order, and in the n-channel well 42, that is, in the p-channel region, a gate oxide film 44b and a gate electrode 45b of an n⁺ polysilicon film are laminated in this order.

A first side wall spacer 49a (about 200 nm thick) of a silicon dioxide film is formed on the side surface of the gate electrode 45a so as to surround the same. A second side wall spacer 49b (about 200 nm thick) of a silicon dioxide film is formed on the side surface of the gate electrode 45b so as to surround the same, and a third side wall spacer 49c (about 200 nm thick) is formed on the outside of the second side wall 49b thus formed.

In this device, as that of the first embodiment, the gate electrode 45a of the n MOS transistor is surrounded only by the first side wall spacer 49a, but the gate electrode 45b is surrounded doubly by the second and third side wall spacers 49b and 49c. As a result, the total thickness of the insulating films around the gate electrode 45b becomes about two times that of the insulating film around the gate electrode 45a.

In the n-channel region, a pair of n⁻ diffusion regions 46 having low impurity concentration and a pair of n⁺ diffusion regions 50 having high impurity concentration are formed symmetrically with respect to the gate electrode 45a. One of the n⁺ diffusion regions 50 becomes the source region and the other thereof becomes the drain region. Similarly, in the p-channel region, a pair of p⁻ diffusion regions 47 having low impurity concentration and a pair of p⁺ diffusion regions 51 having high impurity concentration are formed symmetrically with respect to the gate electrode 45b, one of the regions 51 becoming the source region and the other thereof becoming the drain region.

The structure of the n and p MOS transistors mentioned above is similar to that of the first embodiment.

In the active region adjacent to the n well 42, a base/ emitter region 62 is formed, which comprises an emitter region 61 made of an n⁻ diffusion region and a base region 62a made of an p⁺ diffusion region. On the emitter region 61 is formed an emitter electrode 60 of an n⁺ polysilicon film.

In the active region adjacent to the base/emitter region 62, a collector region 56, that is, the n⁺ diffusion region and a collector electrode 57 of an n⁺ polysilicon film are also formed in this order.. On the side surface of the collector electrode 57, a fourth side wall spacer 49d of a silicon dioxide film which is similar to the second and third side wall spacers 49b and 49c is forced so as to surround the same.

On the surfaces of the gate electrode 45a and first side wall spacer 49a and the surface of the n-channel region of the substrate 41, a second oxide film 48 of the same silicon dioxide as is used for forming the third side wall spacer 49c is provided so as to cover them. The base/ emitter region 62 is covered with the second oxide film 48 while partially remaining respective surfaces of the emitter and base regions 61 and 62a. The surface of the emitter region 61 is contacted to the emitter electrode 60, and the surface of the base region 62a is not covered with the second oxide film 48 but covered with an inter-layer insulating film 64 shown later.

The surface of the collector region 56 is entirely covered with the collector electrode 57. The surface of the collector electrode 57 and the surface of the fourth side wall spacer 49d formed therearound are covered with the second oxide film 48.

A first oxide film of silicon dioxide, which is not shown, is used for forming the first and second side wall spacers 49a and 49b.

The n and p MOS transistors and the bipolar transistor shown above have their surfaces covered with the inter-layer insulating film 64 of silicon dioxide. On the inter-layer insulating film 64, a wiring layer of an aluminum alloy is formed. The wiring layer thus formed is connected through contact holes formed in the inter-layer insulating film respectively to the gate electrodes 45a and 45b, emitter electrode 60 and collector electrode 57.

With the device structured as above, the n⁻ diffusion regions 46 having low impurity concentration are formed in pair beneath the first side wall spacer 49a of the gate electrode 45a of the n MOS transistor and the p⁻ diffusion regions 47 having low impurity concentration are formed in pair beneath the second and third side wall spacers 49b and 49c of the gate electrode 45b of the p MOS transistor, thus making the LDD structure. As a result, the effective channel length of each of the n and p MOS transistors can be increased.

The p⁻ diffusion regions 47 have the length about two times the n⁻ diffusion regions 46 corresponding to the side wall spacer 49a and the side wall spacers 49b and 49c, so that the effective channel length of each of the n and p MOS transistors can be set to the optimum value. As a result, in this second embodiment, as in the first embodiment, satisfactory performance and reliability can be obtained on both n and p MOS transistors.

Next, the production method of the device of the second embodiment as described above will be explained by referring to Figs . 3A to 3D.

First, the n well 42, p well 55 and field oxide film 43 are selectively formed on the silicon substrate 41 having an n-type epitaxial lager, then, an oxide film is selectively formed excepting the area where to become the collector region, an n⁺ polysilicon film (400 nm thick) is deposited thereon and heat-treated at 850 °C for twenty minutes, thus forming the n⁺ diffusion region, that is, the collector diffusion region 56 in the area where to become the collector region in the substrate 41.

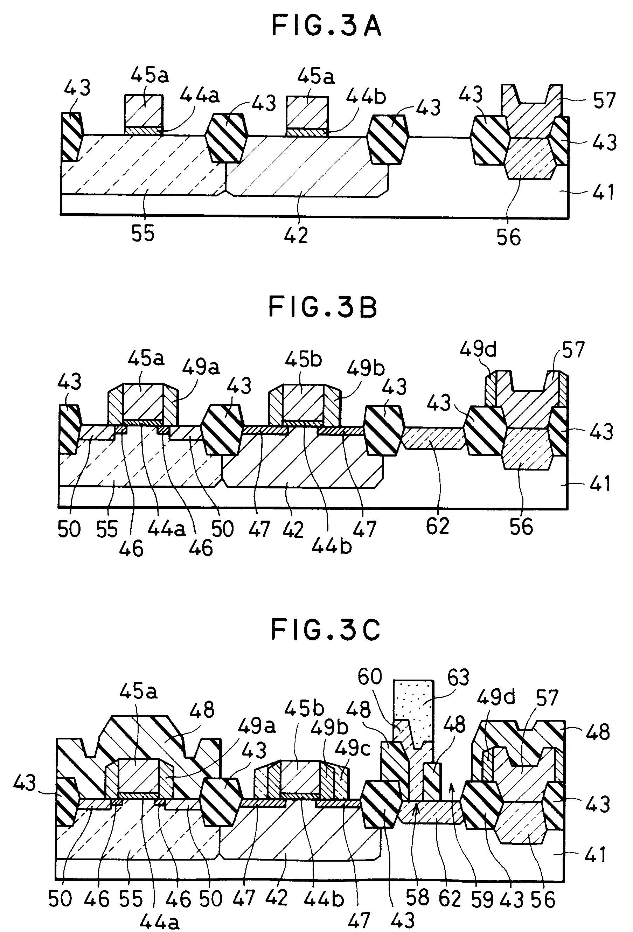

Subsequently, the oxide film thus formed is patterned and the gate insulating film 44a is formed in the n-channel region of the n well 42 and the gate oxide film 44b is forced in the p-channel region of the p well 55. Then, an n⁺ polysilicon film is formed on the entire surface of the substrate 41 which has the collector diffusion region 56 thereon and patterned, thus forming the gate electrodes 45a and 45b respectively on the gate oxide films 44a and 44b and the collector electrode 57 on the collector diffusion region 56, the state of which is shown in Fig. 3A.

Next, phosphorus (P) ion is implanted selectively into the n-channel region at a dose of 5 x 10¹³ cm⁻² with the gate electrode 45a as a mask thereby forming n⁻ diffusion regions 46 in pair in self-alignment. Then, boron (B) ion is implanted selectively into the p-channel region at a dose of 3 x 10¹³ cm⁻² with the gate electrode 45b as a mask thereby forming the p⁻ diffusion regions 47 in pair in self-alignment.

Subsequently, the first oxide film (200 nm thick of silicon dioxide is formed on the entire surface of the substrate 41 by the CVD method, then a mask having a predetermined pattern is disposed thereon and using CHF₃ gas, an anisotropic reactive ion etching is applied to the first oxide film thereby remaining the first oxide film on the side surfaces of the gate electrodes 45a, 45b and the collector electrode 57. Thus, the first and second side wall spacers 49a and 49b (each about 200 nm thick) are formed respectively on the side surfaces of the gate electrodes 45a and 45b. In addition, the fourth side wall spacer 49d also is formed on the side surface of the collector electrode 57. However, the fourth side wall 49d may not be formed.

Next, arsenic (As) ion is implanted selectively into the n-channel region at a dose of 5 x 10¹⁵ cm⁻² with the gate electrode 45a and first side wall 49a as a mask thereby forming the n⁺ diffusion regions 50 in pair in self-alignment, one of the regions 50 becoming the source region and the other thereof becoming the drain region. Also, boron (B) ion is implanted selectively into the area where to become the base/emitter area of the bipolar transistor at a dose of 2,5 x 10¹³ cm⁻². Thus, the p⁻ diffusion region, that is, the base/emitter region 62 is formed in the substrate 41 in self-alignment. At this stage, the ion injection is applied to the p-channel region, the state of which is shown in Fig. 3B.

Next, the second oxide film 48 (200 nm thick) of silicon dioxide is formed on the entire surface of the substrate 41 shown in Fig. 3B by the CVD method, then, a mask having a predetermined pattern is disposed thereon and using CHF₃ gas, the anisotropic reactive ion etching is applied thereto thereby selectively removing the oxide film 48 in the p-channel region and the base/emitter region 62 of the bipolar transistor. Thus, the oxide film 48 is remained on the outside surface of the second side wall spacer 49b of the p MOS transistor, which is made the third side wall spacer 49b (about 200 nm thick). At the same time, the second oxide film 48 is remained as a mask on the emitter/ base region 62 of the bipolar transistor, and through-holes 58 and 59 are formed in thus remained oxide film 48 so as to be extended to the surface of the emitter/ base region 62.

Next, an n⁺ polysilicon film (200 nm thick) is formed on the entire surface of the substrate 41 by the CVD method and patterned by a lithography technology thereby forming the emitter electrode 60 at the area corresponding to the through-hole 58 of the second oxide film 48. The emitter electrode 60 is contacted through the through-hole 58 to the surface of the emitter/base region 62. The surface of the emitter/base region 62 is partially exposed through the through-hole 59 from the second oxide film 48, the state of which is shown in Fig. 3C.

Subsequently, while a resist 63 used in forming the emitter electrode 60 is being remained thereon, boron fluoride ion is selectively implanted into the p-channel region at a dose of 5 x 10¹⁵ cm⁻² with the gate electrode 45b and the second and third side walls 49b and 49c as a mask, and selectively implanted into the emitter/base region 62 of the bipolar transistor at the same dose with the resist 63 on the emitter electrode 20 and the second oxide film 48 as a mask. Thus, the pair of the p⁺ diffusion regions 51 respectively becoming the source and drain regions of the p MOS transistor and the emitter diffusion region 61 of n⁻ diffusion region and the base diffusion region 62 of p⁺ diffusion region are simultaneously formed in self-alignment . The emitter region 61 is formed beneath the through-hole 58 and the base region 62a is formed beneath the through-hole 59.

Then, the resist 63 on the emitter electrode 60 is removed, then, heat-treated under the nitrogen atmosphere for, for example, 900 °C for ten minutes for annealing and the inter-layer insulating film 64 of silicon dioxide is formed on the entire surface thereof, the state of which is shown in Fig. 3D.

After forming contact holes in the inter-layer insulating film 64, the wiring layer of aluminum alloy is formed and patterned, thus finishing the semiconductor integrated circuit device of this second embodiment.

According to the production method of this embodiment, in the semiconductor integrated circuit device having n and p MOS transistors as well as having a bipolar transistor, the n and p MOS transistors can be structured in the LDD formation adapted to the both. In addition, in the MOS transistors, the third side wall spacer 49c is formed around the gate electrode 45b while the second oxide film 48 is being remained and at the same time, in the bipolar transistor, the emitter/base region 62 is covered with the second oxide film 48 having the through-holes 58 and 59, so that the distance between the through-hole 58 for the emitter region 61 and the through-hole 59 for the base region 62a can be always made constant. As a result, without adding a production process, the emitter region 61 and base region 62 can be self-aligned in the optimum positional relationship. Consequently, the production method of this embodiment makes it possible to improve the performance and reliability of the bipolar transistor.

### [Third Embodiment]

A semiconductor integrated circuit device of a third embodiment is shown in Fig. 4, which is a modification of the device of the first embodiment. The device of this embodiment is different from the device of the first embodiment in that the first one has the gate electrode 25b of the p MOS transistor having two side wall spacers 29a and 29b formed of an oxide film therearound and on the other hand, this third embodiment has the gate electrode having a single side wall spacer 29e formed therearound. The side wall spacer 29e has a thickness about two times that of the side wall spacer 29a formed around the gate electrode 25a of the n MOS transistor as shown in Fig. 4. The side wall spacers 29a and 29e each is formed of silicon dioxide.

The other components than the side wall spacer 29e around the gate electrode 25b are similar to those of the first embodiment and indicated at the same reference numerals, and the detailed explanations on them will be omitted here.

It is clear that the device of this third embodiment has the same effects as those of the first embodiment.

In producing the device of this embodiment, with a mask deiposed on the insulating film when the side wall spacers 29a and 29e are formed, a through-hole formed in the mask at the position corresponding to the gate electrode 25b of the p MOS transistor is made larger in size than a through-hole formed in the mask at the position corresponding to the gate electrode 25a of the n MOS transistor. And thereafter the anisotropic reactive ion etching is carried out with using the mask. As a result, only one oxide film may be used for the side wall spacers 29a and 29e.

In each embodiment, the first and second oxide films are anisotropically patterned by the reactive ion etching operation using CHF₃ gas. However, any method can be used for this purpose if it can effect the same action.

Thus, to summarise the preferred embodiments, a semiconductor integrated circuit device having n- and p-type insulated-gate FETs is provided. First and second side wall spacers each made of an insulating film are provided respectively around the gate electrode of the p-type FET and the gate electrode of the n-type FET and, a third side wall spacer made of an insulating film is additionally provided only on the side surface of the second side wall spacer. The first and second side wall spacers are substantially equal in thickness to each other. As a result, the thickness of the spacer of the p-type FET becomes larger than that of the n-type FET, thus being capable of forming the spacers with the optimum thickness respectively for the n- and p-type FETs. Consequently, satisfactory performance and reliability can be provided on both types of the FETs.

## Claims

1. A semiconductor integrated circuit device having n- and p-type insulated-gate field effect transistors formed on a semiconductor substrate, said transistors each having a lightly doped drain structure, wherein;
said n-type insulated-gate field effect transistor has a first side wall spacer made of an insulating film formed around its gate electrode; and
said p-type insulated-gate field effect transistor has a second side wall spacer made of an insulating film formed around its gate electrode and a third side wall spacer made of an insulating film formed on the outside surface of said second side wall spacer.

2. The semiconductor integrated circuit device as claimed in claim 1, wherein said first side wall spacer is substantially equal in thickness to said second side wall spacer.

3. The semiconductor integrated circuit device as claimed in claim 1, wherein said semiconductor substrate has a bipolar transistor formed thereon.

4. The semiconductor integrated circuit device as claimed in claim 3, wherein an insulating film of the same material as that of said insulating film making said third side wall spacer is formed on an emitter region and base region of said bipolar transistor and said emitter region and base region are formed in self-alignment.

5. A production method of a semiconductor integrated circuit device having n- and p-type insulated-gate field effect transistors formed on a semiconductor substrate, said transistors each having a lightly doped drain structure, said production method comprising the steps of:
forming a first side wall spacer and a second side wall spacer, each made of a first insulating film, respectively on the side surface of a gate electrode of said n-type insulated-gate field effect transistor and of the side surface of a gate electrode of said p-type insulated-gate field effect transistor; and
forming a third side wall spacer made of a second insulating film only on the outside surface of said second side wall spacer of said p-type insulated-gate field effect transistor.

6. The production method as claimed in claim 5, wherein the step of forming said third side wall spacer comprises the steps of:
forming a second insulating film so as to cover the surface of both types of said transistors respectively having said first and second side wall spacers formed thereon; and
anisotropically etching said second insulating film so as to remain said second insulating film in a predetermined area around said gate electrode of said p-type transistor and in the area which covers the surface of said n-type transistor therewith.

7. A semiconductor integrated circuit device having n- and p-type insulated-gate field effect transistors formed on a semiconductor substrate, said transistors each having a lightly doped drain structure, wherein;
a side wall spacer made of an insulating film formed on the side surface of a gate electrode of said n-type insulated-gate field effect transistor is larger in thickness than a side wall spacer made of an insulating film formed on the side surface of a gate electrode of said p-type insulated-gate field effect transistor.

8. The semiconductor integrated circuit device as claimed in claim 7, wherein said side wall spacer of said p-type transistor is made of a single insulating film.

9. A production method of a semiconductor integrated circuit device having n- and p-type insulated-gate field effect transistors formed on a semiconductor substrate; said transistors each having a lightly doped drain structure, said production method comprising the steps of:
forming a first side wall and a second side wall, each made of a first insulating film, respectively on the side surface of the gate electrode of said n-type insulated-gate field effect transistor and the side surface of the gate electrode of said p-type insulated-gate field effect transistor;
forming a second insulating film on the surfaces of said n- and p-type transistors respectively having said first and second side walls formed thereon and on the surface of said bipolar transistor; and
forming a etching said second insulating film with a mask disposed on said second insulating film so that said second insulating film around said second side wall spacer of said p-type transistor and in the other area than said emitter region and base region of said bipolar transistor may be removed, and thereby a third side wall spacer is formed of said insulating film remained around said second side wall spacer and at the same time, a masking insulating film having through-holes respectively extended to the surfaces of said emitter region and base region is formed on said emitter region and base region.

10. The production method as claimed in claim 9 comprising the steps of:
forming an emitter electrode on said masking insulating film on said emitter region and base region by a lithography technology; and
performing an ion-implantation into said emitter region and base region, while a resist film used for forming said emitter electrode is being remained thereon, with said remained resist film and said masking insulating film as a mask.
